Europäisches Patentamt

European Patent Office

Office européen des brevets

(19)

(11) Publication number: **0 017 927**
**B1**

(12) **EUROPEAN PATENT SPECIFICATION**

(45) Date of publication of patent specification: **19.09.84**

(51) Int. Cl.³: **G 03 F 7/02**

(21) Application number: **80101945.6**

(22) Date of filing: **10.04.80**

(54) Process for preparing photopolymerized elastomeric printing plates not displaying surface stickiness.

(30) Priority: **12.04.79 JP 44688/79**

(43) Date of publication of application:
**29.10.80 Bulletin 80/22**

(45) Publication of the grant of the patent:
**19.09.84 Bulletin 84/38**

(84) Designated Contracting States:
**BE DE FR GB IT NL**

(56) References cited:
**DE-A-2 263 804**
**FR-A-2 021 570**
**FR-A-2 292 997**
**FR-A-2 318 441**
**FR-A-2 392 411**
**US-A-3 506 440**
**US-A-3 942 259**
**US-A-4 045 231**

(73) Proprietor: **Asahi Kasei Kogyo Kabushiki Kaisha
2-6, Dojimahama 1-chome Kita-ku
Osaka-shi Osaka 530 (JP)**

(72) Inventor: **Nakamura, Shohei
100, Kawanarijima
Fuji-shi, Shizuoka-ken (JP)**
Inventor: **Sugiyama, Shigeru
68, Aoshima
Fuji-shi, Shizuoka-ken (JP)**

(74) Representative: **Schübel-Hopf, Ursula et al
Strehl, Schübel-Hopf, Schulz Patentanwälte
Widenmayerstrasse 17
D-8000 München 22 (DE)**

## Description

The present invention relates to a process for treating the surface of a photopolymerized elastomeric printing plate. More specifically, it relates to a process for removing the stickiness by hardening the said surface, particularly that of the relief shoulders and non-image areas of the plate.

The production of printing plates by means of photo-sensitive elastomeric compositions is generally carried out in such steps as imagewise irradiation, removing of unhardened areas, and drying the resulting plate. The printing plates thus obtained usually have sticky surfaces, particularly on the relief shoulders and in non-image areas of the plate. These sticky surfaces are not only inconvenient in handling, but also cause dust deposition on the surfaces. In the press, sticky plates attract paper dust on their surfaces if the prints are paper materials, and thereby give unsatisfactory print quality. Sometimes these sticky plates even cause paper peeling. Therefore, an after-treatment is required to remove the stickiness from the plate surfaces.

Unlike lithography, the photosensitive elastomeric printing plates form relief images. The image-printing areas of the relief are hardened by exposure to light, whereas relief sides and non-image areas remain semi-hardened. Such semi-hardened surfaces are rather sticky and less reactive, partly due to the extraction of low-molecular weight substances from the photopolymerized elastomeric composition during the removing step. The removal of this stickiness has not been easy. If a photo-sensitive elastomeric composition is molded to form solid sheets, different removing conditions of non-image bearing areas give different depths of the relief (i.e., the difference between the height of relief from the plate base and the height of the non-printing surface). Non-image areas often remain substantially unhardened, rather than semi-hardened, depending upon the washing out conditions. In that case, the removal of the stickiness becomes more difficult.

As methods for removing the surface stickiness from those printing plates prepared from photosensitive resin compositions, there have so far been proposed various methods, which are exemplified by a method in which printing plates are post-exposed to light in the atmosphere, in an inert gas or in a solution, using light sources such as an ultra-violet fluorescent lamp or high-pressure mercury lamp having a central wavelength of about 360 nm, to further proceed with the polymerization and hardening of the surface; a method in which printing plates are coated with various rubber latices or polyvinylidene chloride latex; a method in which an inorganic powder such as talc is deposited on the printing surfaces; a method in which surfaces of printing plates are chemically treated with agents such as oxidizing agents reducing agents, or chlorinating agents; and a method in which printing plates are impregnated with a hydrogen withdrawing agent and thereafter exposed to light having a wavelength of not longer than 300 nm, whereby a dehydrogenation reaction takes place to cause crosslinking.

Among these methods, the method using the deposition of inorganic powder on the surface of printing plates is of no practical use, because the use of such powder is effective only for a limited period, while no permanent effect may be expected.

A photosensitive resin composition contains a soluble polymer, an ethylenically unsaturated compound, and a photopolymerization initiator as essential components. Photosensitive elastomeric compositions containing a soluble polymer having in its main chain the polymeric segments of conjugated diene monomers, such as polybutadiene and polyisoprene, are less sensitive to light. Accordingly, even when printing plates prepared of such a composition are exposed, in a solution or in an inert gas, to light having a wavelength of 300 to 400 nm, the stickiness cannot be removed from their surfaces, particularly from the relief shoulders and non-image surfaces. In order to remove the stickiness from the surfaces, particularly the relief sides and non-image surfaces, of these photopolymerized elastomeric printing plates, it has been common practice to subject the plates to a chlorination treatment by means of an aqueous solution of sodium hypochlorite in hydrochloric acid.

However, this method poses undesirable problems from the hygienic point of view, because it requires the use of a highly toxic chemical which emits, for example, poisonous chlorine gas. For this reason, there is an urgent need for an improvement.

Further the removal of the stickiness is also accomplished, as described above, by impregnating the printing plates with a hydrogen withdrawing agent and exposing them to light having a wavelength of not longer than 300 nm (see US—patent no. 4 202 696, its French counterpart, French patent publication no. 2392411 or its German counterpart, German preliminary publication DE—OS 2821500). This method requires two separate steps of impregnation and exposure to light. In addition, it is disadvantageous in that a hygienically undesirable organic solvent must be used in the impregnation step. This method sometimes causes the plates to be crosslinked by the hydrogen withdrawing agent, thus incurring undesirable results, such as a deterioration of the properties exemplified by a reduced tensile strength and elongation at break.

The inventors of the present invention have made intensive studies to cope with the difficulties found in conventional processes and to develop a simple, effective process for removing the stickiness from the surfaces, particularly from the relief shoulders and non-image surfaces, of those printing plates produced from photosensitive elastomeric compositions. Paying attention to the specific reactivity of double bonds of a polymer obtained by polymerizing conjugated diene monomers, they have found that surface stickiness can be removed from the printing plate surfaces, particularly from the relief shoulders and non-image areas of the printing plates in a simple and thorough manner by producing a printing plate by the steps of imagewise irradiation, removing unhardened areas and drying the resulting plate, followed by exposure to light having a wavelength of not longer than 300 nm. The present invention is based on this finding.

FR—A—2 318 441 discloses a process for preparing a photopolymerized elastomeric printing plate by exposing a photopolymerizable composition containing a solvent soluble polymer having polymeric segments of a conjugated diene monomer in its main chain, at least one ethylenically unsaturated compound and a photopolymerisation intiator to imagewise radiation, removing unhardened areas of the plate and exposing it after drying to light.

The prior art processes for the treatment of photopolymerized resin compositions with light having a wavelength of not longer than 300 nm are exemplified by those of U.S. Patent 3,506,440 and Japanese preliminary publication of patent No. 37131/1976, but these patents are different from the present invention in the following points.

The above cited U.S. Patent 3,506,440 relates to a photoresist mainly comprising polyvinyl cinnamate. The process for its production involves imagewise irradiation, washing with an organic solvent, and then exposure to light having a wavelength in the range of from 2200 to 3400Å to enhance the acid resistance. Because it is a resist, the photoprinted image has a flat form, with no such relief shoulders comprising a semi-hardened material as found in the photopolymerized elastomeric printing plates which are the object of the present invention. Since, in case of a resist, the non-image areas are completely washed away until the underlying metal base becomes exposed, there is no sticky non-image area, such as found in the photopolymerized elastomeric printing plates of the present invention. Therefore, the exposure to light having a wavelength of from 2200 to 3400Å only serves to strengthen the already hardened resist membrane. In this respect, the teaching of that patent is decisively different from the present invention which relates to the removal of surface stickiness from semi- or unhardened areas by utilizing the specific reactivity of the double bonds existing in the polymer segments of conjugated diene monomers. The said effect of the present invention is surprising, as it was to be expected that the surface stickiness cannot be eliminated by a method similar to that as used in case of photopolymerized elastomeric compositions which have no polymer segment of conjugated diene monomers. Furthermore, because the photosensitive resin composition containing polyvinyl cinnamate as the major component has large light absorptivity, it can be hardened only in the form of a membrane of not thicker than several tens of microns, and cannot be used in relief printing, which the present invention is intended for.

Japanese preliminary publication of patent No. 37131/1976 relates to a device for hardening a photocurable coating composition, which is characterized in that the photocurable coating composition can be hardened without any wrinkles by passing the articles to be coated continuously through a device where a high-load type light source having a main wavelength of from 300 to 460 nm and containing no light having a wavelength shorter than 300 nm in the first part and a high-load type light source having a main wavelength of from 230 to 460 nm is provided in the second part of the device. The device of the reference practically cuts the light having a wavelength shorter than 300 nm in the first part of the device, because such a light, when used from the beginning, causes wrinkling. Although this light is not completely cut out in the second part, the total exposure to the light having a wavelength of not more than 300 nm in both the first and second parts is restricted to not more than 10% of the exposure to light having a wavelength of 300 to 460 nm used in the first part. In this respect, the reference is fundamentally different from the present invention which positively utilizes the exposure to light having a wavelength of not longer than 300 nm in the after-treatment step. Furthermore, the process of the reference is intended for the purpose of coating, containing no step of imagewise irradiation and removing unhardened areas. This is another point which makes the reference quite different from the present invention, because the latter is intended to remove surface stickiness from relief shoulders and semi- or unhardened non-image areas from which low molecular weight substances are partly extracted during the removing step.

U.S. Patent No. 4,165,265 relates to a process for exposing a photocurable coating composition to two kinds of light having different ranges of wavelengths for hardening it. The reference, intended for a coating purpose, is also irrelevant to the present invention. This is obvious from the result of Comparative Example 9 of the present invention, which indicates that the stickiness cannot be removed by using a photosensitive composition comprising an unsaturated polyurethane resin which is to be applied according to the reference and subjecting this composition to the steps of imagewise irradiation, removing unhardened areas and drying, followed by the step of exposure to light having a wavelength of shorter than 300 nm, according to the process of the present invention.

It is therefore an object of the present invention to provide a process for preparing a photopolymerized elastomeric printing plate which does not display surface stickiness. The process comprises exposing a photopolymerizable composition to imagewise irradiation, removing unhardened areas of the plate and drying the resulting plate, there being employed as the photopolymerizable composition a composition which is known per se containing, as the essential components, (a) a solvent-soluble polymer having polymeric segments of a conjugated diene monomer in its main chain, (b) at least one ethylenically unsaturated compound and (c) a photopolymerization initiator and further exposing the photopolymerized elastomeric printing plate after drying to light having a wavelength of not longer than about 300 nm.

The printing plates which can be treated in accordance with the process of the present invention can be prepared from a photosensitive elastomeric composition containing, as essential components, (a) a solvent soluble polymer having polymeric segments of a conjugated diene monomer in its main chain, (b) at least one ethylenically unsaturated compound and (c) a photopolymerization initiator.

As examples for the solvent soluble polymer having polymeric segments of a conjugated diene monomer uses as component (a), there may be mentioned unvulcanized homopolymers of conjugated diene monomers, such as butadiene, isoprene and chloroprene, and unvulcanized copolymers of at least one of these conjugated diene monomers with at least one monoolefine monomer, such as styrene, acrylonitrile, $\alpha$-methylstyrene, vinyltoluene, lower alkyl acrylate ester, lower alkyl methacrylate ester, vinyl chloride, and vinyl acetate. In addition, there may be used those polymers obtained by linking these homopolymers or copolymers linearly by ester linkages or urethane linkages.

It is preferred that the component (a) is incorporated in an amount of at least 30% by weight based on the photopolymerizable composition and it is possible to incorporate the component (a) in an amount of at most 98% by weight based on the photopolymerizable composition. The amount of the component (a) may vary depending on the intended physical properties of the printing plate, but from the viewpoints of the rubber elasticity and moldability, it is more preferred that the component (a) be incorporated in an amount of 55 to 95% by weight based on the photopolymerizable composition. If the amount is smaller than the range, the obtained plate does neither exhibit the required elastomeric property, nor exhibit a sufficient effect in removing the stickiness according to the present invention. On the other hand, if the amount is larger than the range, a sufficient photoreactivity of the composition cannot be obtained, owing to the reduced amount of such components as (b) and (c), etc.

The number average molecular weight of the solvent-soluble polymer (a) is preferably in the range of from about 1,000 to about 4,500,000, more preferably in the range of from about 5,000 to about 1,000,000, measured by G.P.C. (gel Permeation Chromatography method using polystyrene as the standard). If the molecular weight is higher than the range, the solubility of the polymer in a solvent is not good, and the processability of molds is poor. On the other hand, if the molecular weight is lower than the range, the plate after hardening does not exhibit sufficiently good properties.

As a solvent which dissolves the polymer, there can be used, for example, 1,1,1-trichloroéthane, tetrachloroethylene, trichloroethylene, tetrachloroethane, toluene and, depending upon the polymer employed, mixtures of such a solvent and 60% or less by weight of an alcohol such as ethanal, isopropanol or n-butanol. In case the polymer has a comparatively low molecular weight and is in a liquid state, in some instances an aqueous solution containing a surface active agent can be used.

As ethylenically unsaturated compounds to be used as the component (b) of the photosensitive elastomeric composition of the present invention, there can be mentioned esters of acrylic acid, methacrylic acid, fumaric acid and maleic acid; derivatives of acrylamide and methacrylamide; N-substituted maleimide; allyl esters and triallyl cyanurate; styrene and derivatives thereof; and the like. Specific examples of the ethylenically unsaturated compounds include ethylene glycol diacrylate, ethylene glycol dimethacrylate, diethylene glycol diacrylate, diethylene glycol dimethacrylate, propylene glycol diacrylate, propylene glycol dimethacrylate, dipropylene glycol diacrylate, dipropylene glycol dimethacrylate, butylene glycol diacrylate, butylene glycol dimethacrylate, polyethylene glycol diacrylate (number average molecular weight: up to 1,500), polyethylene glycol dimethacrylate (number average molecular weight: up to 1,500), polypropylene glycol diacrylate (number average molecular weight: up to 1,500), polypropylene glycol dimethacrylate (number average molecular weight: up to 1,500), trimethylolpropane triacrylate, trimethylolpropane trimethacrylate, pentaerythritol tetraacrylate, pentaerythritol tetramethacrylate, N,N' - hexa - methylene - bis - acrylamide, N,N'-hexa - methylene - bis - methacrylamide, diacetone acrylamide, diacetone methacrylamide, styrene, vinyltoluene, divinylbenzene, diallyl phthalate, triallyl cyanurate, diethyl fumarate, dibutyl fumarate, dioctyl fumarate, didecyl fumarate, dilauryl fumarate, distearyl fumarate, butyl octyl fumarate, lauryl stearyl fumarate, dibehenyl fumarate, diphenyl fumarate, ditolyl fumarate, bis(ethylphenyl) fumarate, bis-(dimethylphenyl) fumarate, bis(hexylphenyl) fumarate, dinaphthyl fumarate, bis(methyl-naphthyl) fumarate, dibenzyl fumarate, bis(3-phenylpropyl) fumarate, bis(6-phenylhexyl) fumarate, bis(2-phenylethyl) fumarate, dibutyl maleate, dioctyl maleate, didecyl maleate, diphenyl maleate, ditolyl meleate, dilauryl maleate, distearyl maleate, dibenzyl maleate and bis(6-phenylhexyl) maleate, N-ethyl maleimide, N-hexyl maleimide, N-decyl maleimide, N-lauryl maleimide, N-phenyl maleimide, N-benzyl maleimide, N,N'-hexamethylene-bis-maleimide, N,N'-phenylene-bis-maleimide. They may be used either alone or in combination. The ethylenically unsaturated compounds employable in the photosensitive elastomeric composition of the present invention are not restricted to those listed above.

The amount of the ethylenically unsaturated compound to be used in the photosensitive elastomeric composition of the present invention may be varied depending on the kind thereof, the intended properties of the printing plate to be produced and the like, but may usually be in the range of from 1 to 50% by weight, preferably in the range of from 4 to 30% by weight, base on the photopolymerizable composition. If the amount of the ethylenically unsaturated compound is too small, the resulting composition may not be sufficiently hardened by exposure to actinic radiation and no sufficient solvent insolubility is attained. Therefore, a part of an area to be formed as a relief is washed away in the solvent washing-out step which is conducted after the imagewise exposure to actinic radiation, and, hence, a satisfactory printing plate cannot be obtained. On the other hand, if the amount of the ethylenically unsaturated compound is too large, the resulting printing plate may be hard or brittle and poor in rubber elasticity, and in some case, the printing plate cannot be used for flexographic printing.

As the photopolymerization initiator (c) effective for the photopolymerizable composition of the present invention, there can be mentioned, for example, benzophenone, Michler's ketone, benzoin, benzoin methyl ether, benzoin ethyl ether, benzoin isopropyl ether, benzoin isobutyl ether, α-methylolbenzoin, α-methylolbenzoin methyl ether, α-methoxy-benzoin ethyl ether, benzoin phenyl ether, α-tert-butyl-benzoin, 2,2-dimethoxy-2-phenylacetophenone, 2,2-diethoxy-2-phenylacetophenone, 2,2-diethoxyacetophenone, benzil, pivaloin, anthraquinone, benzanthraquinones, 2-ethylanthraquinone and 2-chloroanthraquinone. They may be used either alone or in combination.

The photopolymerization initiator may be added in an effective amount for polymerization, i.e., 0.01 to 10% by weight, preferably 0.1 to 3% by weight, based on the photopolymerizable composition.

If the amount is smaller than the above range, no sufficient effect of photo-initiation can be obtained. On the other hand, even if the amount is larger than the range, the obtainable increase of the effect is not so great, but in some cases some physical properties of the plate are deteriorated.

If desired, the photosensitive elastomeric composition of the present invention may further comprise 0.001 to 2 parts by weight, based on 100 parts by weight of the photopolymerizable composition, of a thermal polymerization inhibitor. If the amount is smaller than the range, the effect of improving the heat stability of the plate cannot be obtained. On the other hand, even if the amount is larger than the range, the further improvement of the heat stability of the plate to be expected is not great, but there is caus a rather deleterious effect by preventing or reducing the photopolymerization reaction in the removal of stickiness of the plate.

As such thermal polymerization inhibitors, there can be mentioned, for example, 2,6-di-tert-butyl-p-cresol, p-methoxyphenol, pentaerythritol tetrakis[3 - (3',5' - di - tert - butyl - 4'-hydroxy)phenylpropionate], hydroquinone, tert-butylcatechol, tert-butylhydroxyanisole and 4,4' - butylidene - bis(3 - methyl - 6 - tert - butyl) - phenol.

If desired, the photosensitive elastomeric composition of the present invention may more further comprise a plasticizer. In some cases, the plasticizer promotes the removal of the light-unexposed area of the photosensitive elastomeric composition layer, renders physical properties such as hardness of the cured areas desirable and facilitates the kneading of the raw materials and the formation or molding of the photosensitive elastomeric composition layer. The amount of the plasticizer may be varied according to the intended properties of the photosensitive elastomeric composition layer, it may however usually be used in an amount of 50% by weight or less, preferably 40% by weight or less, based on the photosensitive elastomeric composition. As such plasticizers, there can be mentioned, for example, hydrocarbon oils such as naphthenic and paraffinic oils, low-molecular-weight polystyrene (having a number average molecular weight of 3,000 or less), α - methylstyrene - vinyltoluene copolymers, petroleum resins, pentaerythritol ester of hydrogenated resin, polyterpene resins, polyester resins, polyethylene, poly(α-methylstyrene), polyacrylates, liquid 1,2-polybutadiene, liquid 1,4-polybutadiene, liquid acrylonitrile-butadiene copolymers, liquid styrene-butadiene copolymers, vinyl chloride-vinyl acetate copolymers, stearic acid, polypentadienes, polyurethanes and ethylene-propylene-diene rubbers.

Such photosensitive elastomeric coposi-tions as above-mentioned are described in U.K. Patent 1,366,769, Japanese patent publication No. 37762/1978, U.K. Patent No. 1,522,653, U.S. Patent 4,045,231, French Patent 2292997 and Japanese preliminary publication of patent No. 74703/1976. The process of the present invention is particularly effective for treating the printing plates prepared from a photosensitive elastomeric composition using a fumarate or maleate as the ethylenically unsaturated compound, as described in above-mentioned French patent No. 2292997.

The layer of the photosensitive elastomeric composition usually has a thickness of 0.5 to 7.0 mm.

As the source of actinic radiation that may be used to render the photosensitive elastomeric composition of the present invention solvent-insoluble, there can be mentioned, for example, a low pressure mercury lamp, a high pressure mercury lamp, an ultraviolet fluorescent lamp, a carbon arc lamp, a xenon lamp, a zirconium lamp, sun light and germicidal lamps.

An image is formed in the photosensitive elastomeric composition of the present invention by exposure to actinic radiation through an image-bearing transparency and by making the irradiated relief image area unsoluble in a solvent.

In this step, for improving and facilitating the image formation the photosensitive composition is often irradiated by a greater amount of actinic radiation from the opposite side through the support film, before it is irradiated by actinic radiation through an image-bearing transparency.

The light used for surface treatment accordind to the process of the present invention is required to have a wavelength of not longer than 300 nm. If, however, the plate is exposed to light having a wavelength shorter than 200 nm in the atmosphere, ozone may be generated and cause undesirable results. Therefore, it is preferred to use light having a wavelength in the range of 200 to 300 nm. Using radiation having a wavelength of 300 to 460 nm and containing no light having a wavelength shorter than 300 nm the exposure to light does not remove the stickiness from the surface of the plate and sometimes even increases the stickiness depending on the composition of photosensitive elastomeric compositions. For example, if printing plates are prepared from a photosensitive elastomeric composition comprising a soluble polymer containing polyisoprene segments, an ethylenically unsaturated compound, and a photopolymerization inhibitor, an after-treatment by exposure to light, having a wavelength of from 300 to 460 nm and containing no light of a wavelength shorter than 300 nm produces decomposition products on the plates, and rather increases the surface stickiness. On the contrary, light of a wavelength of not longer than 300 nm does not produce such decomposition products and completely removes the stickiness from the printing plates.

Thus the light employed must have a wavelength of not longer than 300 nm, in order to be able to remove stickiness from the surfaces, particularly from relief sides and non-image areas, of those printing plates obtained by using a soluble polymer containing polymeric segments of conjugated diene monomers in its main chain, together with at least one ethylenically unsaturated compound and photopolymerization initiator. Examples of a light source emitting light with a wavelength of not longer than 300 nm are germicidal lamps, heavy-hydrogen lamps, and low-pressure mercury lamps.

The exposure to light is carried out until the releif sides and non-image surfaces are substantially free from surface stickiness. The time required is usually 1 minute or more, depending on the composition of the photosensitive elastomeric composition used and the capacity of the light source. It is desirable to limit the exposure time to a maximum duration of 30 minutes, because the exposure for a longer period is not only economically disadvantageous, but also may adversely affect the physical properties of the obtained plate. If desired, the exposure can be conducted in an inert gas or in a solution, but advantageously it is conducted in the atmosphere because there is no specific difference in the effectiveness of exposure. When the exposure to light is conducted in the atmosphere, it is preferred to use a light source containing no light having a wavelength of less than 200 nm, as desired above.

In addition to the light exposure step according to the process of the present invention, the printing plates may be subjected, if necessary, to another step of treatment with light having a wavelength of from 300 to 460 nm for the purpose of adjusting the physical properties of the printing plates. In such case, the exposure to light having a wavelength of 300 to 460 nm should take place at the same time as the exposure to light having a wavelength not longer than 300 nm, or following the latter. If on the contrary the printing plates are exposed to light having a wavelength from 300 to 460 nm prior to the exposure to light having a wavelength of not more than 300 nm, the photosensitive elastomeric compositions may produce sticky decomposition products, depending on their composition. Such sticky products may contaminate the plate surfaces and sometimes cannot be removed by the exposure to light having a wavelength of not more than 300 nm. However, in the case of those photosensitive elastomeric compositions which produce no sticky decomposition products upon exposure to light having a wavelength of from 300 to 460 nm, the exposure to such light may precede the exposure to the light having a wavelength not longer than 300 nm.

The relief image areas exposed to light are insoluble in solvents while the unexposed areas are soluble in solvents. For removing the unexposed areas according to the present invention, there may be used methods, which are exemplified by a spraying method such as spraying a solvent from a nozzle to dissolve the unhardened areas or disperse them, and a brushing method with a brush impregnated with such a solvent as above-mentioned.

In this respect, it is necessary that the solvent dissolves the unexposed area but has hardly any influence on the exposed image area.

When the photosensitive elastomeric composition is in the liquid state, the unhardened area can be physically removed by a certain kind of gas.

After the removal of the unhardened areas, the drying of the resulting plate is carried out, to evaporate the solvent, with which the plate might have been swelled in the previous removal step. As representative examples for methods of drying the plate, there may be mentioned a method of blowing heated air to the plate and a method of irradiating with infrared rays.

The process of the present invention allows effective removal of stickiness from the surfaces, particularly from relief shoulders and non-image areas, of printing plates in a simple operation. Therefore, it is useful as an after-treatment in producing printing plates from photosensitive elastomeric compositions.

This invention is further illustrated by the following examples.

Example 1

A mixture of 4 kg of polystyrene-polyisoprene-polystyrene block copolymer prepared by the process described in U.S. Patent No. 3,265,765 (having a styrene content of 14% and a number average molecular weight of 225,000 as measured by G.P.C. (Gel Permeation Chromatography method) using polystyrene as the standard), 1 kg of diethylene glycol dimethacrylate, 100 g of 2,2-dimethoxyphenyl-acetophenon, and 10 g of 2,6-di-tert-butyl-p-cresol were kneaded in a kneader. A part of the kneaded material was sandwiched between two sheets of a 100-$\mu$ thick polyester film. These two sheets, held from each other by spacers of 2 mm thickness placed between, were pressed at 110°C to provide a sheet of the photosentive elastomeric composition. The sheet was exposed to light on one of its surfaces for 5 min. at an intensity of 2.0 mW/cm², using a UV fluorescent lamp. The polyester film was then peeled off from the other unexposed surface. The imagewise irradiation was continued for 15 min., using the same light source but this time making the light pass through an image-bearing transparency. Unhardened areas were then washed out by brushing the surface with a mixture of 1,1,1-trichloroethane-isopropanol (2:1). The printing plate thus obtained was dried at 60°C for 30 min. After allowed to cool to room temperature, the plate surfaces, particularly the relief shoulders and non-image areas, showed stickiness. The plate was then exposed to light for 15 min. in a distance of 10 cm from a light source consisting of three 20 W germicidal lamps which had a central wavelength of 254 nm. After this treatment, the plate had no sticky surface. The plate was further post-exposed to light for 10 min. at an intensity of 2.0 mW/cm², using a UV fluorescent lamp having a central wavelength of 360 nm. No stickiness was found on the plate surfaces.

When this printing plate was used for flexographic printing, the plate provided excellent prints, and essentially did not cause problems concerning the surface stickiness. The plate had high printability, and gave no broken relief during its use in the press.

Comparative Example 1

A sheet of a photosensitive elastomeric composition having the same composition as in Example 1 is as prepared in the same manner as therein. The sheet obtained was subjected to imagewise irradiation, washing out of unhardened areas, and drying the resulting plate, using the same method and conditions as in Example 1. The printing plate thus obtained was then post-exposed to light for 10 min. at an intensity of 2.0 mW/cm², using a U.V. fluorescent lamp (having a central wavelength of 360 nm). In this case sticky decomposition products were formed, and the stickiness of the plate surface increased. The post-exposed plate was then placed at a position in a distance of 10 cm from a light source consisting of three 20 W germicidal lamps which had a central wavelength of 254 nm, and was exposed to light for 15 min., but the stickiness could hardly be removed from the plate surface.

Example 2

A sheet of a photosensitive elastomeric composition was obtained by the same method as in Example 1 from 3 kg of polystyrene-poly-butadiene-polystyrene block copolymer pre-pared by a method described in U.S. Patent No. 3,265,765 (having a styrene content of 30% and a number average molecular weight of 220,000 as measured by G.P.C. using polystyrene as the standard), 1 kg of liquid 1,2-polybutadiene (having a number average molecular weight of 3,000 as measured by G.P.C. using polystyrene as the standard), 500 g of dioctyl fumarate, 100 g of benzoin isobutylether, and 5 g of 2,6-di-tert-butyl-p-cresol. The steps of imagewise irradiation, washing out of unhardened areas, and drying of unhardened areas were carried out in the same manner as in Example 1. The printing plate thus obtained had sticky surfaces, particularly on the relief shoulders and in the non-image areas. The plate was then exposed to light for 10 min. at a position in a distance of 10 cm from the light source consisting of three 20 W germicidal lamps having a central wavelength of 254 nm. After this treatment, the plate exhibited no sticky surface. The plate was further post-exposed to light for 10 min. at an intensity of 2.0 mW/cm$^2$, using a UV fluorescent lamp having a central wavelength of 360 nm. No stickiness was found on the plate surfaces.

Comparative Example 2

A sheet of a photosensitive elastomeric composition having the same compositions as in Example 2 was subjected to imagewise irradiation, washing out of unhardened areas and drying the resulting plate in the same manner as in Example 1. The thus obtained printing plate was placed at a position having a distance of 10 cm from a light source consisting of three 20 W germicidal lamps having a central wavelength of 360 nm, and was post-exposed to light for 10 min., but the stickiness could hardly be removed from the plate surface.

Comparative Example 3

A photosensitive elastomeric sheet of the same composition as in example 2 was prepared in the same manner as in example 1 by kneading and sandwiching the kneaded material between two sheets of a 100 $\mu$m thick polyester film and pressing at 110°C, except that at the time of pressing 1 mm thick spacers were used. The sheet obtained was exposed to light on one surface for 10 min. and on the other surface for another 10 min. at an intensity of 2.0 mW/cm$^2$, using a UV fluorescent lamp having a central wavelength of 360 nm. The polyester film was peeled off from one surface, and the surface was washed with a mixture of 1,1,1-trichloroethaneisopropanol (2:1) and then dried at 60°C for 15 min. The sheet was cut into two pieces. One piece was exposed to light for 10 min. at a position having a distance of 10 cm from a light source consisting of three 20-W germicidal lamps which had a central wavelength of 254 nm. The other piece was immersed in a solution of 0.5% by weight anthraquinone in ethanol for 5 min. and dried at 60°C for 5 min. Thereafter the piece was exposed to light for 10 min. at a position having a distance of 10 cm from a light source consisting of three 20-W germicidal lamps which had a central wavelength of 254 nm.

The remaining polyester film was peeled off from these two pieces of the sheet. Specimens were punched out of the respective sheets, using a dumbbel die according to JIS No. 4 (measured at a head speed of 50 cm/min. and at a temperature of 20°C), and were tested for their tensile properties. The first piece of the sheet, which was only exposed to germicidal lamps, had an elongation at break of 500%, whereas the other sheet, which was treated with an ethanolic solution of anthraquinone, a hydrogen withdrawing agent, prior to the exposure to germicidal lamps, had a lower elongation at break of 300%.

Comparative Example 4

A printing plate was prepared from a sheet of the same photosensitive elastomeric composition as in Example 2, using the same method and conditions as in Example 2, except that the plate was immersed in a solution of 0.5% by weight of anthraquinone in ethanol for 5 min., and dried at 60°C for 5 min. prior to exposure to the germicidal lamps. This printing plate and that obtained in Example 2 were used for flexographic printing. The plate from Example 2 exhibited high printability and high quality of prints. On the other hand, the plate obtained in this Comparative Example, having passed through an additional step of treatment with anthraquinone which is a hydrogen withdrawing agent, caused the formation of cracks on the plate surface during the use in ths press, and hence a drop of the print quality to such a low level that the printing had to be stopped halfway.

Example 3

A sheet of a photosensitive elastomeric composition was prepared in the same manner as in Example 1 from 2 kg of crystalline 1,2-polybutadiene (having a crystallinity of 15% and a number average molecular weight of 200,000 as measured by G.P.C. using polystyrene as the standard), 1 kg of liquid 1,2-polybutadiene (having a number average molecular weight of 2,000 as measured by G.P.C. using polystyrene as the standard), 200 g of tetraethylene glycol diacrylate, 15 g of benzoin isobutyl ether, and 1 g of p-methoxyphenol. The steps of imagewise irradiation, washing out of the unhardened areas, and drying of the resulting plate were carried out in the same manner as in Example 1. The printing plate thus obtained had sticky surfaces, particularly on the relief shoulders and in the non-image areas. The plate was then exposed to ight for 10 min. at a position having a distance of 15 cm from a low-pressure mercury lamp (of the ULO-6DQ type, made by Ushio Electric) having a central wavelength of 254 nm. After this treatment, the plate had no entirely sticky surface.

Comparative Example 5

A sheet prepared as in Example 3 was subjectd to the steps of imagewise irradiation, washing out of unhardened areas and drying in the same manner to give a printing plate having sticky surfaces. A part of the plate was cut out and post-exposed for 10 min. to light at an intensity of 2.2 mW/cm$^2$, using a UV fluorescent lamp having a central wavelength of 370 nm., but the stickiness could hardly be removed from the plate surface.

Example 4

Following the same procedure as in Example 1, except that a press temperature of 150°C was employed, a photosensitive elastomeric sheet was prepared from 2.5 mg of acrylo- nitrilebutadiene copolymer having a nitrile content of 41% (and a Mooney viscosity of 55), 1 kg of dibutyl fumarate, 500 g of trimethylolpropane trimethacrylate, 50 g of 2,2-dimethoxy-2-phenylacetophenone, and 10 g of 2,6-di-tert-butyl-p-cresol. The sheet obtained was subjected to imagewise irradiation in the same manner as in Example 1, and the unhardened areas were then washed out by brushing the plate with 1,1,1-trichloroethane. The washed plate,which was then dried at 60°C for 15 min. and left to cool to room temperature, showed surface stickiness, particularly on the relief shoulders and in the non-image areas. The printing plate was placed at a position in a distance of 10 cm from a light source consisting of three 20-W germicidal lamps which has a central wavelength of 254 nm, and exposed to light for 15 min. No stickiness was found on the surface.

## Comparative Example 6

A sheet prepared as in Example 4 was subjected to the steps of imagewise irradiation, washing out of unhardened areas and drying in the same manner as in the stated example to given a printing plate having sticky surfaces. A part of the plate was cut out and post-exposed to light for 15 min. at an intensity of 2.0 mW/cm², using a UV fluorescent lamp having a central wavelength of 360 nm, but the stickiness could hardly be removed from the plate surface.

## Example 5

A sheet of a photosensitive elastomeric composition was prepared by the same method and conditions as in Example 1 from 2 kg of polychloroprene (having a number average molecular weight of 150,000 as measured by G.P.C. using polystyrene as the standard), 500 g of triethylene glycol dimethacrylate, 500 g of dibutyl fumarate, 30 g of benzoin ethylether, and 5 g of p-methoxyphenol. The sheet was subjected to imagewise irradiation using the same method and conditions as in Example 1, and then the unhardened areas were washed out by brushing with trichloroethylene. The sheet was dried at 60°C for 15 min. After it was left to cool to room temperature, the obtained printing plate had sticky surfaces, particularly on the relief shoulders and in the non-image areas. The plate was exposed to germicidal lamps for 15 min. under the same conditions as in Example 1. After this treatment, the plate had no sticky surface.

## Comparative Example 7

Instead of the germicidal lamps used in Example 5 a UV fluorescent lamp having a central wavelength of 360 nm was used for the post-exposure of a similar plate at an intensity of 2.0 mW/cm² for 15 min. The stickiness could not be removed from the plate surface.

## Comparative Example 8

A mixture of 300 g of hydrogenated 1,2-polybutadiene with terminal hydroxyl groups having an average of 1.6 hydroxyl groups per molecule (having a number average molecular weight of 3,000 as measured by G.P.C. using polystyrene as the standard and a hydrogenation ratio of 95%) and 17.4 g of toluylene diisocyanate (having a 2,4-/2,6-ratio of 3:2) was reacted with stirring at 60°C for 3 hr. under a dry air atmosphere. To the reaction mixture was then added a mixed solution of 8.6 g of 2-hydroxypropyl methacrylate, 0.1 g of hydroxyquinone, and 0.1 g of dibutyl tin dilaurate, and the mixture was reacted at 80°C. The reaction was continued until the IR absorption spectra indicated no absorption characteristic of isocyanate groups (in the vicinity of 2260 cm$^{-1}$), and there was obtained a prepolymer. A photosensitive resin composition was obtained by mixing, while stirring, 100 g of this prepolymer, 40 g of lauryl methacrylate, 10 g of polypropylene glycol dimethacrylate having a number average molecular weight of 400, 3 g of benzoin isobutylether, and 0.1 g of p-methoxyphenol.

On a glass plate was placed a negative photographic film, which was contactingly covered by a 12 $\mu$ thick polyester film. The above prepared photosenstive resin composition was applied on the polyester film to form a layer of 2 mm thickness, which was covered by a 100 $\mu$ thick polyester film. The photosensitive layer was then exposed to light from the side of the 100 $\mu$ thick polyester film for 1 min. at an intensity of 1.5 mW/cm², using a UV fluorescent lamp having a central wavelength of 360 nm. The layer was then subjected to imagewise irradiation from the side of the glass plate through the glass and the negative for 3 min. at a position 30 cm distance from a 3-kW high-pressure mercury lamp. The unhardened areas were then washed out, using an aqueous solution of a nonionic surface active agent, and the sheet was dried at 50°C for 15 min. The printing plate thus obtained had sticky surfaces, particularly on the relief shoulders and in the nonimage areas. It was then exposed to light for 20 min. at a position in a distance of 10 cm from a light source consisting of three 20-W germicidal lamps which had a central wavelength of 254 nm, but the stickiness could hardly be removed from the plate surface.

## Comparative Example 9

To 200 g of polyethylene adipate (of the diol type, having a number average molecular weight of 2,000 as measured by G.P.C. using polystyrene as the standard) were added toluylene diisocyanate (34.8 g, a 2,4-/2,6-ratio of 3:2) and 0.5 g of dibutyl tin dilaurate. The mixture was reacted at 50°C for 4 hr. to give polyethylene adipate having isocyanate groups at both terminals. To this was added 100 g of polypropylene glycol (of the diol type, having a number average molecular weight of 2,000 as measured by G.P.C. using polystyrene as the standard) to provide a polyester-polyether block copolymer (of the type having isocyanate groups at both terminals). To 300 g of this isocyanate-terminated polyester polyether block copolymer were added 25 g of 2-hydroxyethyl methacrylate and 0.1 g of hydroquinone. The mixture was reacted at 70°C for 2 hr. to obtain a prepolymer. A photosensitive resin composition was obtained by mixing with stirring 100 g of this prepolymer, 20 g of 2-hydroxy-propyl methacrylate, 10 g of styrene, 10 g of stearyl methacrylate, 1.5 g of benzoin isopropylether and 0.2 g of hydroquinone.

A sheet of this photosenstive resin composition was subjected to imagewise irradiation by the same method and under the same conditions as in Comparative Example 8, and to the steps of washing out of unhardened areas, using an aqueous solution of a nonionic surface active agent, and drying at 50°C for 15 min. The printing plate thus obtained had sticky surfaces, particularly on the relief shoulders and in the non-image areas. It was then exposed to light for 20 min. at a position in a distance of 10 cm from a light source consisting of three 20-W germicidal lamps which had a central wavelength of 254 nm, but the stickiness could hardly be removed from the plate surface.

Comparative Example 10

A polyvinyl cinnamate photosensitive resin (KPR, a product of Eastman Kodak Company) was poured into a frame. After evaporation of the solvent, there was obtained a 2 mm sheet of the photosensitive resin composition. One surface of this sheet was covered with a 100 $\mu$ thick polyester film coated with an adhesive. The sheet was then exposed from the polyester film side to light having an intensity of 1.5 mW/cm$^2$ for 2 min., using a UV fluorescent lamp having a main wavelength of 360 nm. The other surface of the photosensitive resin sheet was contacted directly with an image-bearing transparency, and the sheet was placed in a vacuum imagewise irradiation frame to bring the sheet in close contact with the negative under vacuum. The sheet was then exposed to light through the image-bearing transparency for 3 min. at a position in a 30 cm distance from a 3-kW high-pressure mercury lamp. The photoprinted sheet was washed with trichloroethylene to washout the unhardened resin. Thereupon the image areas were washed out, and the sheet failed to give a printing plate, because these areas had been hardened only in the thickness of a membrane.

**Claims**

1. A process for preparing a photopolymerized elastomeric printing plate which does not display surface stickiness, comprising exposing a photopolymerizable composition to imagewise irradiation, removing unhardened areas of the plate and drying the resulting plate, there being employed as the photopolymerizable composition a composition which is known per se containing, as the essential components, (a) a solvent-solube polymer having polymeric segments of a conjugated diene monomer in its main chain, (b) at least one ethylenically unsaturated compound and (c) a photopolymerization initiator, and further exposing the photopolymerized elastomeric printing plate after drying to light having a wavelength of not longer than about 300 nm.

2. A process according to claim 1, wherein the solvent-soluble polymer (a) having polymeric segments of a conjugated diene monomer in its main chain is at least one selected from the group consisting of unvulcanized homopolymers of conjugated diene monomers and unvulcanized copolymers of at least one conjugated diene monomer with at least one monoolefin monomer.

3. A process according to claim 1 or 2, wherein the conjugated diene monomer of the component (a) is isoprene.

4. A process according to claim 2 or 3 wherein the monoolefin monomer is at least one selected from the group consisting of styrene, acrylonitrile, $\alpha$-methylstyrene, vinyl-toluene, lower alkyl acrylate ester, lower alkyl methacrylate ester, vinyl chloride, and vinyl acetate.

5. A process according to any of claims 1 to 4, wherein the amount of the component (a) is in the range of from 30 to 98% by weight, preferably from 55 to 95% by weight, based on the total weight of the photopolymerizable composition.

6. A process according to any of claims 1 to 5, wherein the number average molecular weight of the solvent-soluble polymer (a) is in the range of from about 1,000 to about 4,500,000.

7. A process according to any of claims 1 to 6, wherein the component (b) is at least one selected from the group consisting of fumarates and maleates.

8. A process according to any of claims 1 to 7, wherein the amount of component (b) is in the range of from 1 to 50% by weight and the amount of component (c) is in the range of from 0.01 to 10% by weight, based on the total weight of photopolymerizable composition.

9. A process according to any of claims 1 to 8, wherein the exposure to light is carried out in the atmosphere.

10. A process according to any of claims 1 to 9, whegyin the wavelength of the light used for the irradiation is in the range of from 200 to 300 nm.

11. A process according to any of claims 1 to 10, wherein the exposure to light is carried out with a germicidal lamp.

**Patentansprüche**

1. Verfahren zur Herstellung einer photopolymerisierten elastomeren Druckplatte, die keine Oberflächenklebrigkeit zeigt, bei dem eine photopolymerisierbare Zusammensetzung bildmäßig belichtet wird, nichtgehärtete Bereiche der Platte entfernt werden und die resultierende Platte getrocknet wird, wobei als photopolymerisierbare Zusammensetzung eine an sich bekannte Zusammensetzung angewendet wird, die als wesentliche Komponente (a) ein lösungsmittellösliches Polymeres, welches Polymersegmente aus einem konjugierten Dien-Monomeren in der Hauptkette aufweist, (b) mindestens eine ethylenisch ungesättigte Verbindung und (c) einen Photopolymerisationsinitiator enthält, und die photopolymerisierte elastomere Druckplatte nach dem Trocknen erneut mit Licht einer Wellanlänge von nicht mehr als etwa 300 nm belichtet wird.

2. Verfahren nach Anspruch 1, worin das lösungsmittellösliche Polymere (a), das Polymersegmente aus einem konjugierten Dien-Monomeren in der Hauptkette enthält, mindestens eines aus der Gruppe der unvulkanisierten Homopolymeren aus konjugierten Dien-Monomeren und der unvulkanisierten Copolymerein aus mindestens einem konjugierten Dien-Monomeren mit mindestens einem Monoolefin-Monomeren ist.

3. Verfahren nach Anspruch 1 oder 2, worin das konjugierte Dien-Monomere der Komponente (a) Isopren ist.

4. Verfahren nach Anspruch 1 oder 2, worin das Monoolefin-Monomere mindestens eine Verbindung aus der Styrol, Acrylnitril, α-Methylstyrol, Vinyltoluol, niedere Alkylacrylatester, niedere Alkylmethacrylatester, Vinylchlorid und Vinylacetat umfassenden Gruppe ist.

5. Verfahren nach einem der Ansprüche 1 bis 4, worin die Menge der Komponente (a) im Bereich von 30 bis 98 Gew.-%, vorzugsweise von 55 bis 95 Gew.-%, bezogen auf das Gesamtgewicht der photopolymerisierbaren Zusammensetzung, beträgt.

6. Verfahren nach einem der Ansprüche 1 bis 5, worin das Molekulargewicht-Zahlenmittel des lösungsmittellöslichen Polymeren (a) im Bereich von etwa 1000 bis etwa 4 500 000 liegt.

7. Verfahren nach einem der Ansprüche 1 bis 6, worin die Komponente (b) mindestens eine Verbindung aus der aus Fumaraten und Maleaten bestehenden Gruppe ist.

8. Verfahren nach einem der Ansprüche 1 bis 7, worin die Menge der Komponente (b) im Bereich von 1 bis 50 Gew.-% und die Menge der Komponente (c) im Bereich von 0,01 bis 10 Gew.-%, bezogen auf das Gesamtgewicht der photopolymerisierbaren Zusammensetzung, liegen.

9. Verfahren nach einem der Ansprüche 1 bis 8, worin die Belichtung an der Atmosphäre durchgeführt wird.

10. Verfahren nach einem der Ansprüche 1 bis 9, worin die Wellenlänge des zur Belichtung verwendeten Lichtes im Bereich von 200 bis 300 nm liegt.

11. Verfahren nach einem der Ansprüche 1 bis 10, worin die Belichtung mit einer Sterilisations-Lampe (Germizid-lampe) durchgeführt wird.

**Revendications**

1. Procédé de préparation d'une plaque d'impression en élastomère photopolymérisé qui ne présente pas un état collant de surface, comprenant l'exposition d'une composition photopolymérisable à une irradiation de formation d'une image, l'enlèvement des zones non durcies de la plaque et le séchage de la plaque résultante, en employant, comme composition photopolymérisable, une composition qui est connue et qui contient, comme composants essentiels, (a) un polymère soluble dans des solvants ayant des segments polymériques d'un monomère diène conjugué dans sa chaîne principale, (b) au moins un composé à insaturation éthylénique et (c) un initiateur de photopolymérisation, et de plus l'exposition de la plaque d'impression en élastomère photopolymérisé, après séchage, à de la lumière ayant une longueur d'onde ne dépassant pas environ 300 nm.

2. Procédé selon la revendication 1, où le polymère (a) soluble dans des solvants ayant des segments polymériques d'un monomère diène conjugué dan sa chaîne principale est au moins un polymère choisi dans le groupe consistant en homopolymères non vulcanisés de monomères diènes conjugués et copolymères non vulcanisés d'au moins un monomère diène conjugué avec au moins un monomère de monooléfine.

3. Procédé selon la revendication 1 ou 2, où le monomère diène conjugué du composant (a) est de l'isoprène.

4. Procédé selon la revendication 2 ou 3, où le monomère de monooléfine est au moins un monomére choisi dans le groupe consistant en styrène, acrylonitrile, α-méthylstyrene, vinyltoluène, ester d'acrylate d'alcoyle inférieur, ester de méthacrylate d'alcoyle inférieur, chlorure de vinyle et acétate de vinyle.

5. Procédé selon l'une quelconque des revendications 1 à 4, où la quantité du composant (a) est comprise entre 30 et 98% en poids, de préférence entre 55 et 95% en poids, en se basant sur le poids total de la composition photopolymérisable.

6. Procédé selon l'une quelconque des revendications 1 à 5, où le poids moléculaire moyen en nombre du polymère soluble dans les solvants (a) est compris entre environ 1.000 et environ 4.500.000.

7. Procédé selon l'une quelconque des revendications 1 à 6, où le composant (b) est au moins un composant choisi dans le groupe consistant en fumarates et maléates.

8. Procédé selon l'une quelconque des revendications 1 à 7, où la quantité de composant (b) est comprise entre 1 et 50% en poids et la quantité du composant (c) est comprise entre 0,01 et 10% en poids, en se basant sur le poids total de la composition photopolymérisable.

9. Procédé selon l'une quelconque des revendications 1 à 8, où l'exposition à la lumière est mise en oeuvre à l'atmosphère.

10. Procédé selon l'une quelconque des revendications 1 à 9, où la lonqueur d'onde de la lumière utilisée pour l'irradiation est comprise entre 200 et 300 nm.

11. Procédé selon l'une quelconque des revendications 1 à 10, où l'exposition à la lumière est effectuée avec une lampe germicide.